# EUROPEAN PATENT APPLICATION

(11) **EP 3 468 325 A1**
(43) Date of publication of application: **10.04.2019**
(21) Application number: 17275159.6
(22) Date of filing: 06.10.2017
(51) Int. Cl.: H05K 7/20

(54) **SYSTEM COMPRISING AN ENERGY SUPPLY AND A HEAT EXCHANGER**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

A system 200 comprising an energy supply 210, an electrical device 220 and a heat exchanger 230, including a coolant fluid 232, is provided. The energy supply 210 comprises an electrochemical cell 211 and is arranged to supply up to an amount of electrical energy to the electrical device 220. An operation time of the electrical device, in use, is defined, at least in part, by the amount of electrical energy supplied by the energy supply 210. The electrical device 220 is arranged to output, in use, at least a part of the supplied energy as heat to the heat exchanger 230 via the coolant fluid 232. The heat exchanger 230 comprises a phase change material (PCM) 233 arranged to, in use, control, at least in part, a temperature of the coolant fluid 232 to at most a first threshold temperature during the operation time.

## Description

### Field

The present invention relates generally to thermally-managed electrical devices. More particularly, the present invention relates to a system comprising an energy supply, an electrical device and a heat exchanger including a coolant fluid and a phase change material (PCM) arranged to, in use, control, at least in part, a temperature of the coolant fluid.

### Background to the invention

Electrical devices typically output heat, for example as waste heat. Some electrical devices require thermal management, so as to operate within predefined temperature ranges. Thermal management may, for example, improve reliability and/or efficiency of the electrical devices, prevent premature failure of components of the electrical devices and/or enable the electrical devices to operate as designed. Some electrical devices having relatively low waste heat outputs, for example central processing units (CPUs), may include heat sinks and/or fan cooling. Other electrical devices, having relatively high waste heat outputs, may require fluid cooling, so as to remove heat more rapidly. For example, electrical devices such as laser power supplies may require water cooling to maintain these electrical devices within manufacturer-defined temperature ranges during operation. Likewise the optical pump modules of the laser and the laser gain medium both need to maintained within a narrow manufacturer defined temperature. For example, laser power supplies and separately the optical modules for a fibre laser may output waste heat due to electrical losses in electrical drive circuits, electrical losses within laser diode pump sources for the fibre lasers and/or laser optical pumping losses within active fibre cores of the fibre lasers. Typically, lasers have to be pumped at shorter wavelengths than those at they and so significant amounts of waste heat may be due to changes in photon energies between pumped photons and lasing photons. Furthermore, these electrical devices, having relatively high waste heat outputs, typically have relatively high power consumptions, usually provided by mains power supplies. Thus, installed systems for these electrical devices, electrically coupled to mains power supplies, may also include water-cooled heat exchangers.

A problem arises when portability of these thermally-managed electrical devices is required, since portability of the power supplies and of the thermal management is also required. This may be particularly problematic if size and/or mass, for example, are limiting constraints for portability.

Hence, there is a need to improve thermally-managed electrical devices.

### Summary of the Invention

The example embodiments have been provided with a view to addressing at least some of the difficulties that are encountered with current thermally-managed electrical devices, whether those difficulties have been specifically mentioned above or will otherwise be appreciated from the discussion herein.

According to a first aspect of the invention, there is provided a system comprising an energy supply, an electrical device and a heat exchanger including a coolant fluid;
wherein the energy supply comprises an electrochemical cell and is arranged to supply up to an amount of electrical energy to the electrical device;
wherein an operation time of the electrical device, in use, is defined, at least in part, by the amount of electrical energy supplied by the energy supply;
wherein the electrical device is arranged to output, in use, at least a part of the supplied energy as heat to the heat exchanger via the coolant fluid; and
wherein the heat exchanger comprises a phase change material (PCM) arranged to, in use, control, at least in part, a temperature of the coolant fluid to at most a first threshold temperature during the operation time;
whereby portability of the system is provided.

According to a second aspect of the invention, there is provided a heat exchanger including a coolant fluid;
wherein the heat exchanger comprises a phase change material (PCM) arranged to, in use, control, at least in part, a temperature of the coolant fluid to at most a first threshold temperature during an operation time.

### Detailed Description of the Invention

According to the first aspect of the invention, there is provided a system comprising an energy supply, an electrical device and a heat exchanger including a coolant fluid;
wherein the energy supply comprises an electrochemical cell and is arranged to supply up to an amount of electrical energy to the electrical device;
wherein an operation time of the electrical device, in use, is defined, at least in part, by the amount of electrical energy supplied by the energy supply;
wherein the electrical device is arranged to output, in use, at least a part of the supplied energy as heat to the heat exchanger via the coolant fluid; and
wherein the heat exchanger comprises a phase change material (PCM) arranged to, in use, control, at least in part, a temperature of the coolant fluid to at most a first threshold temperature during the operation time;
whereby portability of the system is provided.

In this way, portability of the system may be provided, thereby allowing manual handling of the system by an operator and/or operation of the electrical device remotely from mains electrical supplies, for example, while providing sufficient thermal management for the electrical device during the operation time. It should be understood that portability of the system refers to manual portability of the system by a human operator, for example a single human operator and/or by two operators. Generally, in safe manual handling of equipment by such operators, mass of the equipment should typically not exceed 25 kg for the single operator.

Particularly, the energy supply comprising the electrochemical cell may substitute for a mains electrical supply, as conventionally used with the electrical device for example, thereby portably providing required electrical energy to the electrical device. In this way, the electrical device may be operated remotely from mains electrical supplies, for example, as described below in more detail.

Furthermore, the heat exchanger comprising the PCM may portably provide required thermal management of the electrical device by having a reduced mass compared with a conventional heat exchanger, for example, as described below in more detail. The heat exchanger may also be known as and/or comprise and/or be a heat sink.

### Phase change materials

PCMs are materials having high heats of fusion and which upon changing phase at respective phase change temperatures such as by melting and solidifying, are capable of storing and/or releasing large amounts of energy. PCMs may be classified as latent heat storage (LHS) units.

Latent heat storage can be achieved through liquid-solid, solid-liquid, solid-gas and liquid-gas phase changes. However, only solid-liquid and liquid-solid phase changes are generally practical for PCMs.

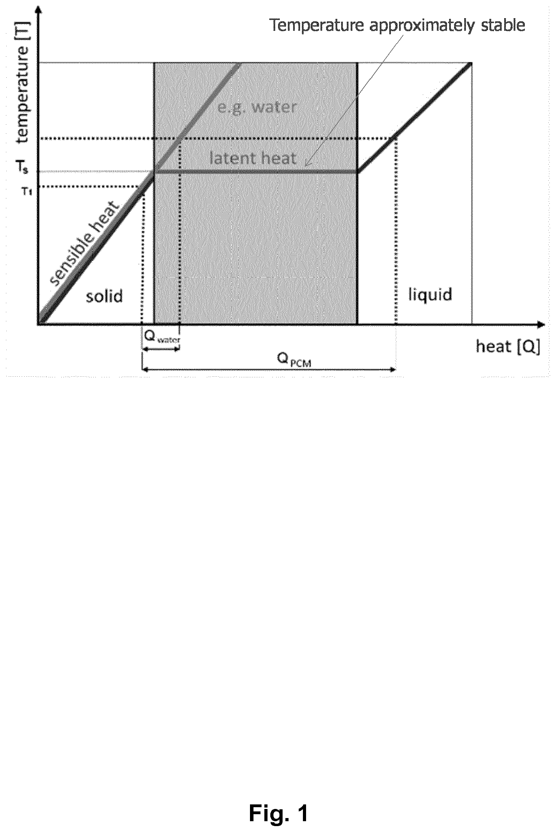

Figure 1 schematically depicts a typical temperature profile of a solid-liquid PCM during thermal loading. Initially, below a temperature Tₛ, the PCM behaves as a sensible heat storage (SHS) material such that a temperature of the PCM rises as the PCM absorbs heat. Unlike conventional SHS materials, however, when the PCM reaches a phase change temperature Tₛ at which it changes phase (i.e. melting temperature), the PCM absorbs large amounts of heat at an almost constant temperature. The PCM continues to absorb heat without a significant rise in temperature until all the PCM is transformed to the liquid phase. When the ambient temperature around a liquid material falls, the PCM solidifies, releasing its stored latent heat. In this way, PCMs may store about 5 to about 14 times more heat per unit volume than conventional storage materials such as water, masonry or rock.

In one example, the PCM comprises at least one of an organic PCM, an inorganic PCM, an eutectic PCM, a hygroscopic PCM, a solid-solid PCM and a thermal composite.

In selection of a PCM, one or more of the following properties may be desirable: phase change temperature in a desired operating temperature range, high latent heat of fusion per unit volume, high specific heat, high density and high thermal conductivity, small volume change on phase transformation, small vapour pressure at operating temperatures, congruent melting, high nucleation rate to avoid supercooling of a liquid phase, high rate of crystal growth, chemical stability, reversibility of phase change, absence of degradation due to phase change, non-corrosiveness, non-toxic, non-flammable, low cost and/or availability.

Organic PCMs include, for example, paraffins (CₙH₂ₙ₊₂), carbohydrates and lipid-derived materials. Beneficial properties of organic PCMs may include freezing without much undercooling, melting congruently, self nucleation, compatibility with conventional material of construction, no or little segregation, chemically stability, high heat of fusion, safe and non-reactivity and/or recyclability. In addition, carbohydrate and lipid based PCMs may be produced from renewable sources. However, organic PCMs may have low solid thermal conductivity, require high heat transfer rates during the freezing cycle, low volumetric latent heat storage capacity and/or flammability. To obtain reliable phase change points, manufacturers typically provide technical grade paraffins, which are essentially paraffin mixture(s) and are completely refined of oil.

Inorganic PCMs include salt hydrates (MₙH₂O), for example. Beneficial properties of inorganic PCMs may include high volumetric latent heat storage capacity, availability, low cost, sharp melting point, high thermal conductivity, high heat of fusion and/or non-flammability. However, inorganic PCMs may have high change of volume, super cooling in solid-liquid transition and/or nucleating agents may be required.

Organic and inorganic PCMs are available from Rubitherm Technologies GmbH (Berlin, Germany), for example, having phase change temperatures in a range of from -9 °C to 90 °C. Heat storage capacities of these PCMs range typically from 150 kJ/kg to 290 kJ/kg. Suitable PCMs available from Rubitherm Technologies GmbH are detailed in Table 1.

**Table 1: Example PCMs available from Rubitherm Technologies GmbH**

| Product | Phase change temperature | Heat storage capacity |
|---|---|---|
| RT 18 HC | 18°C | 260 kJ/kg |
| RT 21 | 21°C | 155 kJ/kg |
| RT 21 HC | 21°C | 190 kJ/kg |
| RT 22 HC | 22°C | 190 kJ/kg |
| RT 24 | 24°C | 160 kJ/kg |
| RT 25 | 25°C | 170 kJ/kg |
| RT 25 HC | 25°C | 230 kJ/kg |
| RT 26 | 26°C | 180 kJ/kg |
| RT 28 HC | 28°C | 250 kJ/kg |

Eutectic PCMs include, for example, c-inorganic and inorganic-inorganic compounds. Beneficial properties of eutectic PCMs may include sharp melting point and/or improved volumetric storage density compared with organic PCMs.

Hygroscopic PCMs include, for example, natural building materials such as wool insulation and earth/clay render finishes, that can absorb and release water.

Solid-solid PCMs undergo solid/solid phase transitions with associated absorption and release of large amounts of heat, having latent heats comparable with solid/liquid PCMs. Nucleation may not be required to prevent supercooling. Currently the temperature range of solid-solid PCMs are available having phase change temperatures in a range of from 25°C to 180°C.

In one example, the PCM has a phase change temperature in a range of from 10°C to 40°C, preferably of from 15°C to 35°C, more preferably of from 18°C to 30°C, for example 25°C.

In one example, the PCM has a heat storage capacity in a range of from 100 kJ/kg to 1000 kJ/kg, preferably of from 150 kJ/kg to 500 kJ/kg, more preferably of from 200 kJ/kg to 300 kJ/kg, for example 230 kJ/kg.

In one example, a mass of the PCM included in the heat exchanger is in a range of from 0.1 kg to 25 kg, preferably of from 1 kg to 15 kg, more preferably of from 2 kg to 10 kg, for example 5 kg.

In one example, the PCM comprises an encapsulated PCM.

Encapsulation of the PCM may be required for PCMs undergoing solid - liquid phase transformations. Example of encapsulation include macro-encapsulation, micro-encapsulation and molecular encapsulation. Macro-encapsulation with large volume containment may be unsuitable for PCMs having low thermal conductivity, since such PCMs tend to solidify at edges of the macro-encapsulation, thereby preventing effective heat transfer. Micro-encapsulation generally allows PCMs to be incorporated into construction materials, for example by coating a microscopic sized PCM with a protective coating. Molecular-encapsulation allows a very high concentration of PCM within a polymer compound.

In one example, the encapsulated PCM is divided into cells. The cells may be arranged to reduce static head. Walls of the cells may provide effective heat transfer, restrict passage of water through the walls, resist leakage and/or corrosion and/or may be chemically compatible with the PCM. Cell wall material examples include stainless steel, polypropylene and polyolefin.

In one example, the PCM comprises an additive arranged to increase a thermal conductivity of the PCM.

Some PCMs, for example some organic PCMs, may have high heats of fusion but low thermal conductivities. By including additives within the PCM, the thermal conductivity of the PCM may be increased, thereby improving heat absorption of the PCM, for example. The additives may include, for example, particles, fibres or wires, having high thermal conductivities. Use of carbon microspheres in PCMs is described by Zhihua Cao, Kai Zhang, Guoping Zhang, Matthew M. F. Yuen, Ping Gu, Xianzhu Fu, Rong Sun and C. P. Wong (2014) High performance phase change thermal interface materials based on porous graphitic carbon spheres-paraffin wax composite, Electronic Components and Technology Conference (ECTC), 2014 IEEE 64th, DOI: 10.1109/ECTC.2014.6897325. Use of TiO₂ nanoparticles in PCMs is described by Mohammed Ouikhalfan, Hassan Benmhamed, Hassan Chehouani and Brahim Benhamou (2015) Thermophysical investigation of a TiO2 embedded phase change material, 3rd International Renewable and Sustainable Energy Conference (IRSEC), DOI: 10.1109/IRSEC.2015.7455010. In particular, addition of 0.3 wt.% of TiO₂ nanoparticles to the commercial PCM compound PCM60 (Kaplan Energy, Brignais, France) increased thermal conductivity of the PCM by 43% in the liquid state and by 21% in the solid state. The addition of these nanoparticles resulted in very small changes (<5%) to the latent heat capacity of the PCM. In one example, the PCM comprises the additive in an amount of at least 0.1 wt.%, at least 0.2 wt.% or at least 0.3 wt.%. In one example, the PCM comprises the additive in an amount of at most 0.5 wt.%, at most 1 wt.% or at most 5 wt.%.

The electrical device may require an inlet temperature of the coolant fluid water to be within a manufacturer-defined temperature range during operation.

The first threshold temperature may be a predetermined temperature. For example, the first threshold temperature may predetermined by a manufacturer of the electrical device and/or may be a maximum permissible inlet temperature of the coolant fluid into the electrical device. In this way, overheating of the electrical device may be avoided, for example. A second threshold temperature may be defined, being predetermined by the manufacturer of the electrical device and/or may be a minimum permissible inlet temperature of the coolant fluid into the electrical device. In this way, undercooling and/or freezing of the electrical device may be avoided, for example. In one example, the first threshold temperature is in a range of from 10°C to 50°C, preferably of from 20°C to 40°C, more preferably of from 25°C to 35°C, for example 30°C. In one example, the second threshold temperature is in a range of from 5°C to 40°C, preferably of from 10°C to 30°C, more preferably of from 15°C to 30°C, for example 18°C. The first threshold temperature is higher than the second threshold temperature.

In one example, a phase change temperature of the PCM is at most the first threshold temperature.

In this way, the PCM may absorb at least a part of the heat output, in use, by the electrical device to the heat exchanger via the coolant fluid at or below the first threshold temperature, thereby improving efficiency of heat absorption of the PCM during the operation time.

In one example, a phase change temperature of the PCM is at least the second threshold temperature. In one example, a phase change temperature of the PCM is in a range of from the second threshold temperature to the first threshold temperature.

In this way, the PCM may absorb at least a part of the heat output, in use, by the electrical device to the heat exchanger via the coolant fluid between the second threshold temperature and the first threshold temperature, thereby improving efficiency of heat absorption of the PCM during the operation time.

In one example, a phase change temperature of the PCM is at least ambient temperature, in use. The ambient temperature should be understood as a temperature of the environment and/or surrounding air in which the electrical device is operated by an operator, for example. The ambient temperature may be an average daily ambient temperature (i.e. the average ambient temperature over any given 24 hour period). Thus, the PCM may be selected, based at least in part, on expected ambient temperature. In this way, the PCM may absorb at least a part of the heat output, in use, by the electrical device to the heat exchanger via the coolant fluid between the ambient temperature and the first threshold temperature, for example, thereby improving efficiency of heat absorption of the PCM during the operation time.

### Operation time

The operation time of the electrical device, in use, is defined, at least in part, by the amount of electrical energy supplied by the energy supply. Generally, electrochemical cells store energy and may provide at most this stored energy. Thus, the operation time of the electrical device may be limited, for example, by at most an amount of energy stored in the electrochemical cell. In practice, not all of the stored energy may be discharged and hence the operation time of the electrical device may be limited by the amount of electrical energy supplied and/or suppliable by the energy supply. The operation time may be a continuous operation time or a discontinuous operation time. In one example, the operation time is a continuous operation time.

For example, if the energy supply is arranged to provide up to the amount of energy E to the electrical device, having an input power P, the operation time t of the electrical device may be at most t = E / P. In one example, the operation time is predetermined and the energy supply is selected to supply at most the amount of energy during the operation time. By selecting the energy supply, for example the electrochemical cell, at least in part on this basis, a size and/or mass of the energy supply and hence the system may be reduced. The operation time may be in a range of from 60 seconds to 3600 seconds, preferably of from 60 seconds to 600 seconds, more preferably from 300 to 600 seconds.

The electrical device is arranged to output, in use, at least the part of the supplied energy as heat to the heat exchanger via the coolant fluid and the heat exchanger comprises the PCM arranged to, in use, control, at least in part, the temperature of the coolant fluid to at most the first threshold temperature during the operation time. If the electrical device is arranged to output heat H during the operation time t to the heat exchanger via the coolant fluid, the heat exchanger may be arranged to absorb, for example dissipate, up this heat H. A part of this heat H may be absorbed by the PCM so as to control, for example limit, a rise in temperature of the coolant fluid such that the temperature of the coolant fluid is at most the first threshold temperature during the operation time. In one example, the operation time is predetermined and the PCM is selected to absorb at most a part of the heat during the operation time so as to control, for example limit, a rise in temperature of the coolant fluid such that the temperature of the coolant fluid is at most the first threshold temperature during the operation time. By selecting the PCM, at least in part on this basis, a size and/or mass of the heat exchange and hence the system may be reduced.

In one example, the energy supply and the heat exchanger are selected for the electrical device to reduce, for example optimise or minimise, a size and/or a mass of the system. That is, the energy supply and the heat exchanger are matched to electrical device. In this way, the energy supply is arranged to provide at most the amount of energy required during the operation time of the electrical device and the heat exchanger comprising the PCM is arranged to, in use, control, the temperature of the coolant fluid to at most the first threshold temperature during the operation time, while optimising or minimising a size and/or a mass of the system.

### Electrochemical cell

In one example, the electrochemical cell is selected from a group comprising a non-rechargeable electrochemical cell, a rechargeable electrochemical cell and a fuel cell. Non-rechargeable electrochemical cells (also known as primary cells) are arranged to be discharged into loads only once, after which they are discarded. In general, electrochemical reactions occurring in non-rechargeable electrochemical cells are not reversible. In contrast, rechargeable electrochemical cells (also known as secondary cells) are arranged to be charged, discharged into loads, and subsequently recharged. Typically, various combinations of electrode materials and electrolytes are used in rechargeable electrochemical cells, including lead-acid, nickel cadmium (NiCd), nickel metal hydride (NiMH), lithium ion (Li-ion), and lithium ion polymer (Li-ion polymer also known as LiPo or LIPO). Li-ion polymer rechargeable electrochemical cells provide higher energy densities than Li-ion rechargeable electrochemical cells, at reduced mass compared with lead-acid, NiCd and NiMH rechargeable electrochemical cells, and are hence preferred. Fuel cells are electrochemical cells that convert chemical energy from hydrogen-containing fuels into electricity through electrochemical reactions of the fuel with oxygen or another oxidizing agent. Fuel cells include metal hydride fuel cells, electro-galvanic fuel cells, direct formic acid fuel cells (DFAFC), zinc-air cells, microbial fuel cells, upflow microbial fuel cells (UMFC), regenerative fuel cells, direct borohydride fuel cells, alkaline fuel cells, direct methanol fuel cells, reformed methanol fuel cells, direct-ethanol fuel cells, proton exchange membrane fuel cells, RFC - redox cells, phosphoric acid fuel cells, solid acid fuel cells, molten carbonate fuel cells, tubular solid oxide fuel cells (TSOFC), protonic ceramic fuel cells, direct carbon fuel cells, planar solid oxide fuel cells, enzymatic biofuel cells and magnesium-air fuel cells.

In one example, the electrical supply, for example the electrochemical cell, has a capacity in a range of from 1 to 1000 Ah, preferably 1 to 100 Ah, more preferably 1 to 50 Ah, for example 15 Ah.

In one example, a mass of the electrical supply, for example the electrochemical cell, is in a range of from 0.1 kg to 25 kg, preferably of from 1 kg to 15 kg, more preferably of from 2 kg to 10 kg, for example 5.8 kg.

In one example, the system comprises a voltage regulator arranged to regulate a voltage at which the electrical energy is supplied by the energy supply to the electrical device. For example, the energy supply may comprise the voltage regulator. In this way, a stable voltage, for example, may be provided by the electrical voltage to the electrical device. Generally, voltages output by electrochemical cells may depend, at least in part, on discharge currents and/or discharge temperatures of the electrochemical cells. Voltage regulators, such as DC to DC converters, may provide improve stability of the voltage during discharging. In one example, the electrical supply comprises a DC to DC converter, arranged to regulate a voltage at which the electrical energy is supplied by the energy supply to the electrical device.

### Electrical device

In one example, the electrical device comprises an industrial electrical device. In one example, the electrical device comprises a mains-powered, industrial electrical device. In one example, the electrical device comprises an industrial, thermally-managed electrical device. In one example, the electrical device comprises a mains-powered, industrial, thermally-managed electrical device. In one example, the electrical device comprises an optically pumped element or part thereof. For example, the optically pumped element may comprise a photonic device pumped via an umbilical in which an active optical element of the optically pumped element outputs heat. In one example, the electrical device comprises a laser power supply. The laser power supply may be for a CO₂ laser, a neodymium (Nd) laser and/or a neodymium yttrium-aluminium-garnet (Nd-YAG) laser, a Ytterbium (Yt) glass fibre laser. In one example, the system comprises such a laser.

In one example, the electrical device has a power consumption in a range of from 1 to 10 kW, preferably 2 to 8 kW, more preferably 3 to 7 kW, for example 5.4 kW. In one example, the electrical device has a heat output of from 0.5 to 8 kW, preferably 1 to 6 kW, more preferably 2 to 5 kW, for example 3.8 kW or 4.5 kW.

### Heat exchanger - other

In one example, the system comprises a pump arranged to circulate the coolant fluid. For example, the heat exchanger may include the pump. The energy supply may be arranged to supply electrical energy to the pump. The coolant fluid may be recirculated by the pump i.e. a recirculating coolant fluid.

In one example, the coolant fluid comprises a liquid, preferably water. Liquids typically have higher thermal specific heat capacities and/or thermal conductivities than gases. However, liquids typically have higher densities than gases. Water cooling may be typically used for industrial electrical devices. Water is inexpensive, non-toxic and has a high specific heat capacity.

In one example, a flow rate of the coolant is in a range of from 1 to 100 litres per minute, preferably 2 to 50 litres per minute, more preferably 5 to 30 litres per minute, for example 15 litres per minute.

In one example, the heat exchanger comprises a cooling fin. In this way, the heat exchanger may improve cooling of the coolant fluid. In one example, the heat exchanger comprises a plurality of cooling fins.

In one example, the heat exchanger comprises a housing. The housing may be arranged to encapsulate the PCM. The heat exchanger, for example the housing, may be arranged to accommodate expansion and/or contraction of the PCM, for example, during phase change of the PCM and/or due to thermal expansion of a phase of the PCM. The housing may be arranged to provide a channel (also known as conduit) or a plurality of channels for the coolant therethrough. The housing may comprise the cooling fin and/or the plurality of cooling fins.

In one example, the system comprises a thermoelectric heat pump arranged to, in use, control, at least in part, the temperature of the coolant fluid to at most the first threshold temperature during the operation time and/or cool the PCM material from liquid back to solid. Thermoelectric heat pumps, such as Peltier chillers, may provide cooling to overcome background thermal loading of the PCM material from the ambient environment, for example. Additionally and/or alternatively, thermoelectric heat pumps, such as Peltier chillers, may provide cooling to reverse a change of the PCM material from liquid back to solid.

According to the second aspect of the invention, there is provided a heat exchanger including a coolant fluid;
wherein the heat exchanger comprises a phase change material (PCM) arranged to, in use, control, at least in part, a temperature of the coolant fluid to at most a first threshold temperature during an operation time.

The heat exchanger, the coolant fluid and the PCM may be as described according to the first aspect.

### Brief description of the drawings

For a better understanding of the invention, and to show how exemplary embodiments of the same may be brought into effect, reference will be made, by way of example only, to the accompanying diagrammatic Figures, in which:
Figure 1 schematically depicts a typical temperature profile of a phase change material during thermal loading;
Figure 2 schematically depicts a block diagram of a system according to an exemplary embodiment of the invention;
Figure 3 schematically depicts another system according to an exemplary embodiment of the invention;
Figure 4 schematically depicts a perspective view of a part of an heat exchanger of the system of Figure 3, in use;
Figure 5 schematically depicts a perspective view of the part of the heat exchanger of Figure 4, in more detail;
Figure 6 schematically depicts results of computational fluid dynamic (CFD) modelling of the part of the heat exchanger of Figure 4;
Figure 7 schematically depicts results of computational fluid dynamic (CFD) modelling of the system of Figure 3; and
Figures 8A and 8B schematically depict voltage discharge characteristics of a LIPO battery cell as functions of discharge current and temperature, respectively.

### Detailed Description of the Drawings

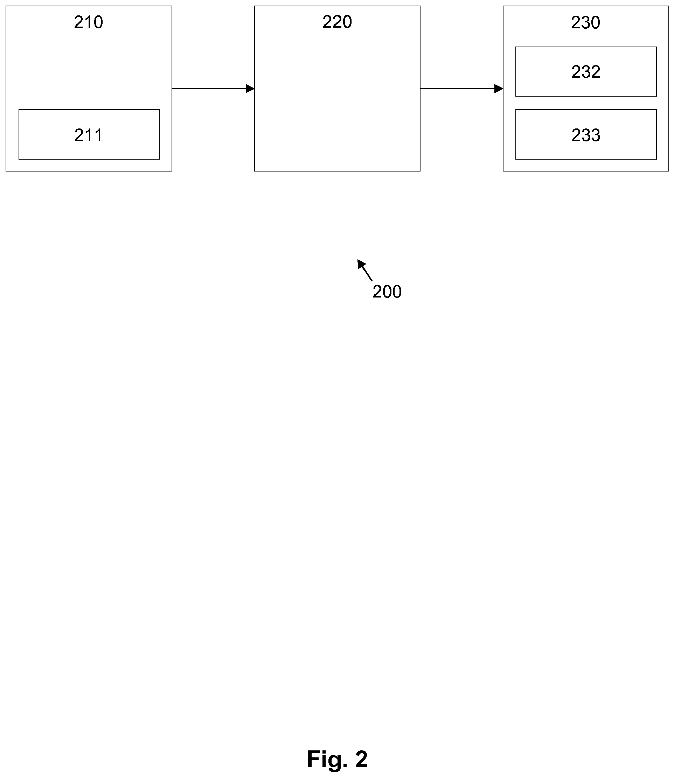

Figure 2 schematically depicts a system 200 according to an exemplary embodiment of the invention.

The system 200 comprises an energy supply 210, an electrical device 220 and a heat exchanger 230 including a coolant fluid 232. The energy supply 210 comprises an electrochemical cell 211 and is arranged to supply up to an amount of electrical energy to the electrical device 220. An operation time of the electrical device 220, in use, is defined, at least in part, by the amount of electrical energy supplied by the energy supply 210. The electrical device 220 is arranged to output, in use, at least a part of the supplied energy as heat to the heat exchanger 230 via the coolant fluid 232. The heat exchanger 230 comprises a phase change material (PCM) 233 arranged to, in use, control, at least in part, a temperature of the coolant fluid 232 to at most a first threshold temperature during the operation time.

In this way, portability of the system 200 may be provided, thereby allowing manual handling of the system 200 by an operator and/or operation of the electrical device 220 remotely from mains electrical supplies, for example, while providing sufficient thermal management for the electrical device during the operation time. Particularly, the energy supply 210 comprising the electrochemical cell 211 may substitute for a mains electrical supply, as conventionally used with the electrical device 220 for example, thereby portably providing required electrical energy to the electrical device 220. Furthermore, the heat exchanger 230 comprising the PCM 233 may portably provide required thermal management of the electrical device 220 by having a reduced mass compared with a conventional heat exchanger, for example.

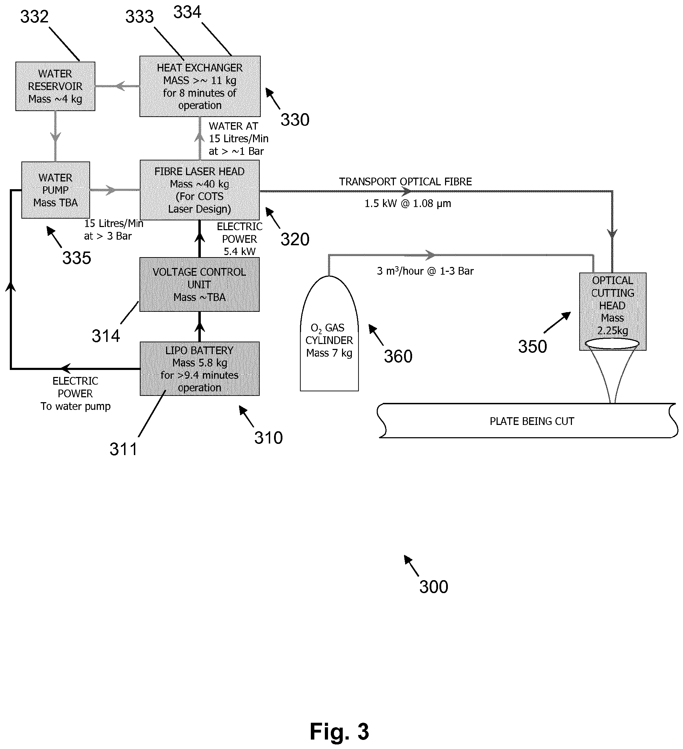

Figure 3 schematically depicts another system according to an exemplary embodiment of the invention. The system 300 comprises an energy supply 310, an electrical device 320 and a heat exchanger 330 including a coolant fluid 332. The energy supply 310 comprises an electrochemical cell 311 and is arranged to supply up to an amount of electrical energy to the electrical device 320. An operation time of the electrical device 320, in use, is defined, at least in part, by the amount of electrical energy supplied by the energy supply 310. The electrical device 320 is arranged to output, in use, at least a part of the supplied energy as heat to the heat exchanger 330 via the coolant fluid 332. The heat exchanger 330 comprises a phase change material (PCM) 333 arranged to, in use, control, at least in part, a temperature of the coolant fluid 332 to at most a first threshold temperature during the operation time. Like reference signs denote like features, description of which will not be repeated for brevity.

In this example, the system 300 comprises a field deployable laser cutting system 300. The system 300 may, for example, be used to support rescue work following a serious road accident when rescue services need to rapidly cut an access route into a vehicle to a driver and/or a passenger. Current car build standards extensively use high tensile steel safety structures to enhance crash safety. However, conventional cutting techniques, for example hydraulic cutters, may be unable to cut sufficiently quickly through such safety structures and/or may not be able to cut through such safety structures. The system 300 may thus provide a capability to cut through such safety structures, but without a need to transport into the field a heavy power pack and water chiller, for example. The system 300 may, for example, provide a reusable one shot round system capable of operating the 1.5 kW laser (the electrical device 320) for at least 8 minutes (480 seconds). This should provide sufficient operational time to cut an access route to road traffic victims within for example the crumpled safety cage of a road vehicle.

The electrochemical cell 311 includes 2 LIPO battery cells, as described below in more detail. Briefly, the electrochemical cell 311 includes 2 LIPO battery cells (37 V 22 Amp hours and 11.1 V 22 Amp hours, respectively) which may be used to power the system 300 including the electrical device 320 for nominally 11.7 minutes. The energy supply 310 further comprises a voltage regulator 314, specifically a DC to DC converter, arranged to regulate a voltage at which the electrical energy is supplied by the energy supply 310 to the electrical device 320 and thus generate a stable voltage output during a discharge cycle of the electrochemical cell 311. The electrochemical cell 311 is electrically coupled to the voltage regulator 314 which is in turn electrically coupled to the electrical device 320. The electrical device 320 is a fibre laser head, more specifically a Yttrium glass fibre laser head, optically coupled via an optical fibre 340 to an optical cutting head 350. Also shown is an oxygen cylinder 360 coupled via a flexible high pressure gas line to the optical cutting head 350, regulated to provide oxygen at about 3 m³/hour at a pressure of from 1 to 3 bar (i.e. from 100 kPa to 300 kPa), for oxygen-assisted laser cutting. Generally, pressurised oxygen may assist laser cutting of mild steel, high tensile steel and stainless steel plates/rods, yielding a much faster cutting rate due to the exothermic reaction of oxygen with iron to form FeO. In addition, formation of FeO helps to lubricate the molten melt thus requiring a lower gas pressure to blow the molten metal out of the cut. In the case of stainless steel, oxygen is only appropriate if the quality of the final cut finish is unimportant such as for a cutting access to road traffic victim, for example. Oxygen is not appropriate when cutting either aluminium or non-metallic barriers. For these metals, high pressure nitrogen gas is a better choice. Likewise for stainless steel if a high quality cut is required. Argon gas is preferred if cutting titanium. The heat exchanger 330 includes the coolant fluid 332, specifically water. The heat exchanger comprises a housing 334. The heat exchanger 330 is fluidically coupled to the electrical device 320. The heat exchanger 330 comprises a pump 335 arranged to recirculate the coolant fluid 332 through the electrical device 320. The energy supply 310 is arranged to supply electrical energy to the pump 335. The system 300 further includes a Peltier cooler 336 (not shown) coupled to the heat exchanger 330, which provides cooling to overcome background thermal loading of the PCM 333 from the ambient environment during transportation of the system to the remote work location.

In more detail, the PCM 333 is selected to have a phase change temperature of nominally 25 °C. This phase change temperature is sufficiently below a maximum input temperature (i.e. the first threshold temperature) of 30 °C predetermined by a manufacturer of the electrical device 320 and is a maximum permissible inlet temperature of the coolant fluid 332 into the electrical device 320, such that the heat exchanger 330 functions efficiently. In addition, this phase change temperature is also sufficiently high that thermal loading of the PCM 333 by the external ambient environment may be reduced using thermal lagging. As a consequence, only a low power Peltier cooler 336 is required to maintain the PCM 333 at a nominal initial temperature of 21 °C. This may provide close to a maximum possible thermal heat sink capacity before the temperature of the PCM 33 starts to rise rapidly.

This one shot round system 300 provides a human-portable cutting fibre laser system 300 of laser output power ∼1.5kW: one human operator to transport the laser head (i.e. the electrical device 320) of mass approximately 40 kg, and another human operator to carry the energy supply 310 and the heat exchanger 330. This system 300 may be sufficient to carry out laser cutting for about 8 minutes of continuous operation, for example, sufficient to cut an approximately 8 metre long path through 10 mm thick steel under optimal cutting conditions for the laser.

In more detail, a maximum optical output of most commercially available air cooled ytterbium glass lasers is typically limited to approximately 300 - 500 W. 300 W at ∼1 µm spot size is sufficient to cut through 2 mm steel, but it will not cut through a 10 mm thick plate of steel. 500 W can cut through ∼8 mm of mild steel with an oxygen assist gas, but cutting through much thicker plates may be challenging. Hence, for cutting steel of thickness of at least 10 mm, a laser of ∼1.5 kW or higher may be required. Such high powered lasers typically require thermal management including water cooling.

In this example, the laser (i.e. the electrical device 320) is a SPI Lasers 1.5 kW redPOWER (RTM) Prism Fibre laser, having a rated electrical power consumption of 5.4 kW and a rated thermal load to a water cooling system of 3.8 kW. A permissible temperature range for the coolant fluid 311 is 18 °C to 30 °C at a flow rate of 15 litres per minute. Details of the laser (i.e. the electrical device 320) are summarised in Table 2.

**Table 2: SPI Lasers 1.5 kW redPOWER (RTM) Prism Fibre laser**

| **redPOWER® prism 1.5kW** | | | **Parameter Value** |
|---|---|---|---|
| Wavelength | | nm | 1080 ± 2 |
| Max, output Power | | kW | 1.5 |
| Pulse Rise/Fall Times | | µs | <5/<6 |
| Max. Modulation frequency | | kHz | 50 |
| Beam Quality (Fibre diameter dependent) As defined in ISO 11146 | 20µm Fibre | M² | 1.1 |
| | | BPP (mm.mrad) | 0.38 |
| | 50µm Fibre | BPP (mm.mrad) | 2.1 |
| | 100µm Fibre (enhanced) | BPP (mm.mrad) | 3.3 |
| | 100µm Fibre | BPP (mm.mrad) | 4.5 |
| Beam Divergence (full angle) (86% power enclosed) | 20µm Fibre | mrad | 8.2 |
| | 50µm Fibre | mrad | 170 |
| | 100µm Fibre (enhanced) | mrad | 130 |
| | 100µm Fibre | mrad | 180 |
| Max Output Fibre Length (for 1.5kW output power) | | m | 10 m for 20µm fibre, 20 m for 50µm & 100µm fibres. |
| Optical Fibre connector type | | - | PIPA-Q Output Connector |
| Electric Drive Voltage | | V DC | 48 |
| Electric Drive Current | | A | 135 (Max) |
| Max. Power Consumption | | kW | 5.4 |
| Mass Laser Output Module | | kg | <40 |
| Ambient Temperature range | | °C | 5 to 45 1kW |
| Humidity | | RH | 5 to 85%, 35°C Max Dew Point |
| Coolant Flow Rate | | Litres/minute | 15 |
| Coolant temperature range | | °C | +18 to +30 |
| Dimensions Output Module | | mm | 89×445×702 |
| | | (h×w×l) | (19" rack mount) |

By way of example, a cutting task requires cutting a 600 mm diameter hole through a 10 mm thick plate of mild steel. This task would take ∼3.2 minutes at an expected cutting speed of 10 mm/second if a circular path were cut. Thermal management for the laser 320 therefore would need to dissipate a total of at least 730 kJ of thermal energy (i.e. heat) to perform the task. If water at a temperature of 20 °C were available, a water reservoir having at least ∼17.5 litres water (i.e. the coolant fluid) would be required to dissipate this heat while also remaining below the 30 °C temperature limit throughout the duration of the task. This large volume and mass of water would have to be transported for use of the system in the field. This required volume of the water would scale linearly with the required operation time of the laser. This required volume of the water would scale inversely with the temperature difference between the initial water temperature and the first threshold temperature of 30 °C. In addition, water at 20 °C may not be available. A conventional portable chiller capable of dissipating heat of ∼3.8 kW is not a practical solution for a field deployable system, since such a conventional chiller is not portable.

Therefore, thermal management is required, as provided by the heat exchanger 33, in which the PCM 333 provides a thermal heat load battery during the operation of the laser 320.

In this example, the PCM 333 is Rubitherm Technologies GmbH RT 25HC. RT 25HC is an organic PCM having a phase change temperature about 25 °C, as summarised in Table 3.

**Table 3: Properties of Rubitherm Technologies RT 25HC PCM**

| Property | Typical values | Units |
|---|---|---|
| Melting area | 22 - 26 (main peak 25) | °C |
| Congealing area | 26 - 22 (main peak 25) | °C |
| Heat storage capacity ±7.5% | 230 | kJ/kg |
| Combination of latent and sensible heat a temperature range of 16°C to 31°C | 64 | Wh/kg |
| Specific heat capacity | 2 | kJ/kg.K |
| Density solid at 15 °C | 0.88 | kg/l |
| Density liquid at 40 °C | 0.77 | kg/l |
| Heat conductivity (both phases) | 0.2 | W/m.K |
| Volume expansion | 12.5 | % |
| Flash point | 150 | °C |
| Max. operation temperature | 65 | °C |

RT25 HC has a phase change temperature of nominally 25 °C that is significantly lower than the maximum inlet water temperature of 30 °C that is required for the SPI fibre laser system. This helps the functionality of the heat exchanger by accelerating the rate of heat transfer from the water channel to the PCM 333. The phase change temperature of ∼25 °C is higher than the average temperature over any given 24 hour period (i.e. average daily temperature) in many parts of the world outside of the tropics. Thus, the electrical power needed to maintain the PCM in its solid state may therefore be reduced, for example minimised, particularly if the heat exchanger 330 is thermally well insulated from the external ambient atmosphere.

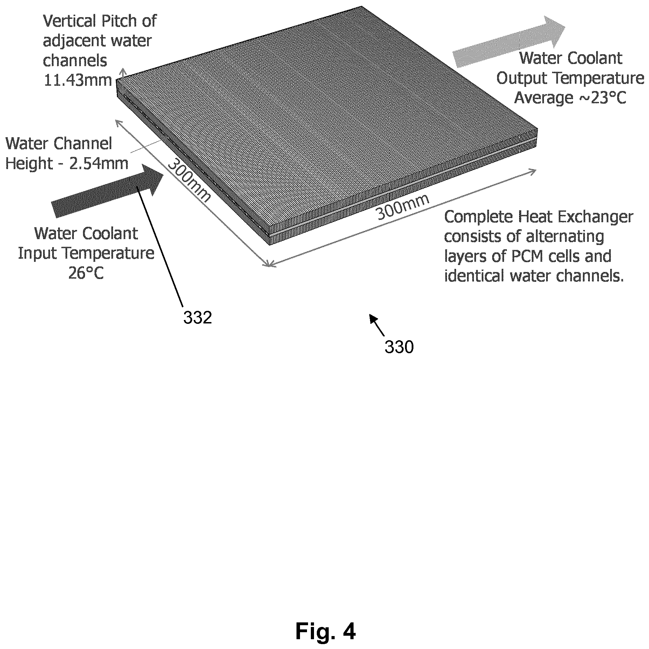

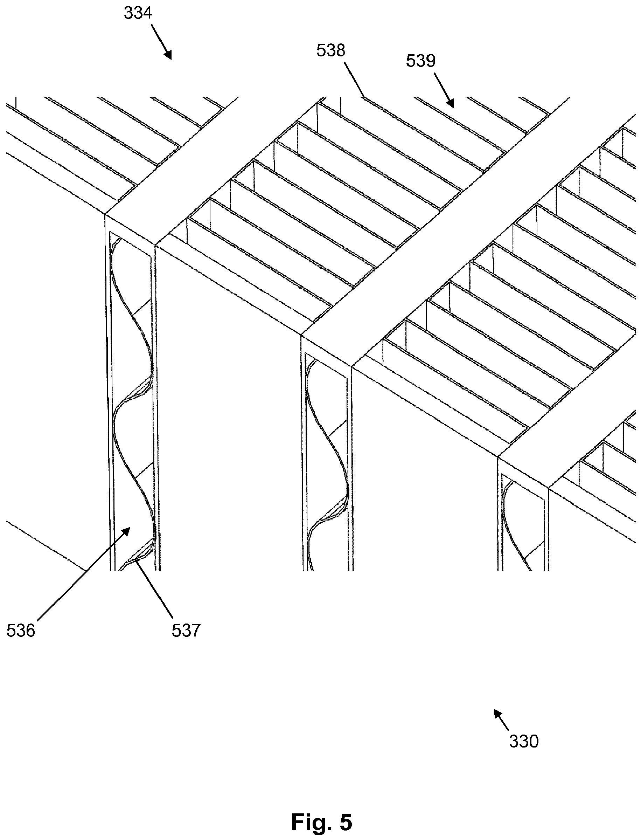

Figure 4 schematically depicts a perspective view of a part of the heat exchanger 330 of the system 300, in use. Figure 5 schematically depicts a perspective view of the part of the heat exchanger 330 of Figure 4, in more detail.

Water (i.e. the coolant fluid 332) is passed through a 300 mm wide water channel 536 of height 2.54 mm and length 300 mm in the housing 334. The overall water channel 536 is divided up into series of parallel isolated streams by a corrugated aluminium spacer 537 that is brazed to two aluminium plates of thickness 0.27 mm that form the top and bottom walls of the water channel. The pitch of the corrugations 537 in the aluminium spacer is 11.6 mm. Each of these plates is thermally connected to thin aluminium fins 538 of thickness 0.102 mm. These aluminium fins 538 define an array of PCM wax cells 539 that are each 1.7 mm wide and 8.89 mm tall. These aluminium fins 538 also transport heat from the water channel to the PCM wax cells 539 that collectively act as a thermal heat sink for the system 300. The PCM wax cells 539 accommodate expansion and/or contraction of the PCM, for example, during phase change of the PCM and/or due to thermal expansion of a phase of the PCM.

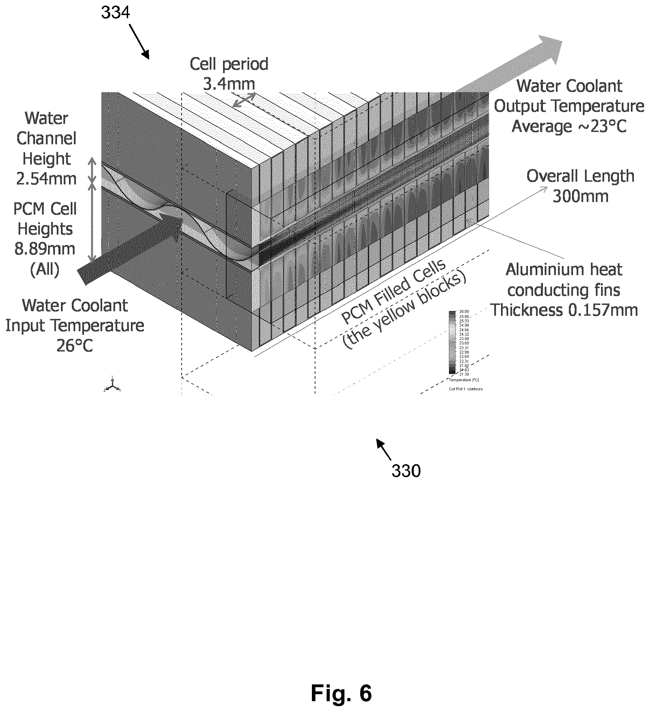

Figure 6 schematically depicts results of computational fluid dynamic (CFD) modelling of the part of the heat exchanger 330 of Figure 4.

In detail, CFD modelling was performed using SolidWorks Flow Simulation. The heat exchanger 330 includes 11 water channels 536, as shown in Figures 4 and 5, with a vertical pitch between the adjacent water channels 536 of 11.4 mm. Each of the 11 water channels 536 were sandwiched by a pair of PCM cell 539 layers, making a total of 12 PCM cell 539 layers for the heat exchanger 330. The overall dimensions of the heat exchanger housing 334 are therefore 300 × 300 × 134.3 mm³. Laser 320 operating parameters and heat exchanger 330 parameters for the CFD are summarised in Table 4 and 5 respectively.

**Table 4: Laser operating parameters for the CFD.**

| **Parameter** | **Symbol** | **Units** | **Value** |
|---|---|---|---|
| Laser Thermal Load† | Q | kW | 4.5 |
| Water Coolant Flowrate | VFR | Litres/min | 15 |
| | MFR | kg/s | 0.25 |
| Water Temperature Rise | ΔT | °C | 4.3 |
| Specific Heat Capacity of Water | Cₚ | J/kg/K | 4180 |
| Water Density | | kg/Litre | 1 |
| | | Kg/m³ | 1000 |
| Water Dynamic Viscosity at 25°C | | Ns/m³ | 0.0009 |

**Table 5: Heat exchanger parameters tor the CFD.**

| **Parameter** | **Units** | **Value** |
|---|---|---|
| PCM volume (in the liquid state) | m³ | 0.00762 |
| | litres | 7.62 |
| Flow length | mm | 300 |
| Water Channel height | mm | 2.54 |
| HX width | mm | 300 |
| Flow Speed | m/s | 0.03 |
| Single Water Channel Flow Area | m² | 0.000762 |
| Flow rate per channel | kg/s | 0.02286 |
| Number of water channels | | 11 |
| Number of PCM Chambers | | 12 |
| Calculated Fin Height to achieve PCM Volume | mm | 8.4697 |
| Marston Fin Height | mm | |
| Fin Pitch | Mm | 1.58333333 |
| Hydraulic Diameter | mm | 5 |
| Water flow Reynolds Number | | 168 |
| | | Laminar |

An approximate mass of the heat exchanger 330 is about 13.3 kg, including coolant fluid 332 (2.5 kg), PCM 333 (5.9 kg) and housing 334 (4.9 kg), including fins 538 (1.944 kg). That is, the total mass of coolant (mass of the coolant fluid plus the mass of the PCM) is only 8.4 kg and thus less than half of the mass of the water (-17.5 kg) that would be conventionally required if water only were used, as described above. By including -0.3 wt.% TiO₂ nanoparticles in the PCM 333 to improve thermal conductivity, as described above, spacing of the fins 538 may be increased, thereby reducing the mass of the housing.

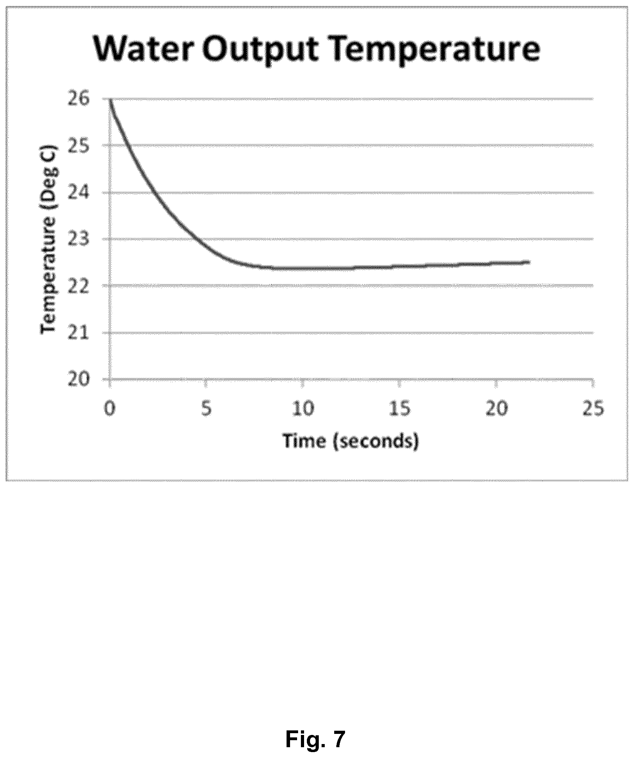

Figure 7 schematically depicts results of computational fluid dynamic (CFD) modelling of the system of Figure 3. Particularly, Figure 7 shows the first approximately 20 seconds of the modelled transient water temperature of the water (i.e. the coolant fluid) at the output from the heat exchanger 330 for a flow rate of 15 litres per minute. The temperature of the water at the inlet port was set to be 26 °C. The thermal load to the heat exchanger 330 was set at 4.5 kW. The water flow speed through the heat exchanger 330 was set to be 30 mm/s. The output water temperature rapidly falls to ∼22.3 °C within ∼8 seconds, before then rising slowly thereafter over the intended operational duration of ∼5 minutes.

The electrochemical cell 311 includes 2 LIPO battery cells, as described above. A field deployable cutting laser requires battery power as electrical mains power will not in general be available. The SPI Laser's 1.5 kW Prism Fibre laser of this example requires an electrical supply at 48 V DC with a continuous current draw of ∼112.5 A, and a peak current capability of 135 A. Hence, the energy supply 310 requires a capacity of at least 15 Ah to achieve the 8 minutes operation time. When selecting an electrochemical cell, it is good practice to ensure that the theoretical capacity of the electrochemical cell is approximately 30% to 40% larger than that required. The LIPO battery cells are supplied by Krystan Limited under the trade name UK Overlander, as detailed below in Tables 6 and 7, respectively. These LIPO battery cells are capable of supplying at 48 V DC either 440 A continuously (equivalent to 21.1 kW) for about 3 minutes, and both will support a 660 A peak current. These LIPO battery cells consist of respectively 10 and 3 LIPO cells (each of nominally 3.7 V DC), arranged in series to yield the specified voltages of 37 V and 11.1 V. These two LIPO battery cells together when connected in series would have a nominal output voltage of 48.1 V DC and have enough capacity to power SPI Laser's 1.5 kW Prism Fibre laser for nominally up to 11.7 minutes. The combined mass of the two batteries is 5.8 kg.

**Table 6: Technical Specification of a Kryston Ltd's UK Outlander 11.1 Volt LIPO battery cell. Full designation of battery is 22000 mAh 3S 11.1 V 20C LIPO Battery - Overlander SupersportXL.**

| **Parameter** | **Units** | **Value** |
|---|---|---|
| Voltage (DC) | V | 11.1 |
| Max Sustained Current | A | 440 |
| Max Peak Current | A | 660 |
| Capacity | Ah | 22 |
| Length | mm | 202 |
| Width | mm | 97 |
| Depth | mm | 36 |
| Mass | kg | 1.32 |

**Table 7: Technical Specification of a Kryston Ltd's UK Overlander 37 Volt LIPO battery cell. Full designation of battery is 22000 mAh 10S 37 V 20C LIPO Battery - Overlander SupersportXL.**

| **Parameter** | **Units** | **Value** |
|---|---|---|
| Voltage (DC) | V | 25.9 |
| Max Sustained Current | A | 440 |
| Max Peak Current | A | 660 |
| Capacity | Ah | 22 |
| Length | mm | 202 |
| Width | mm | 97 |
| Depth | mm | 120 |
| Mass | kg | 1.5 |

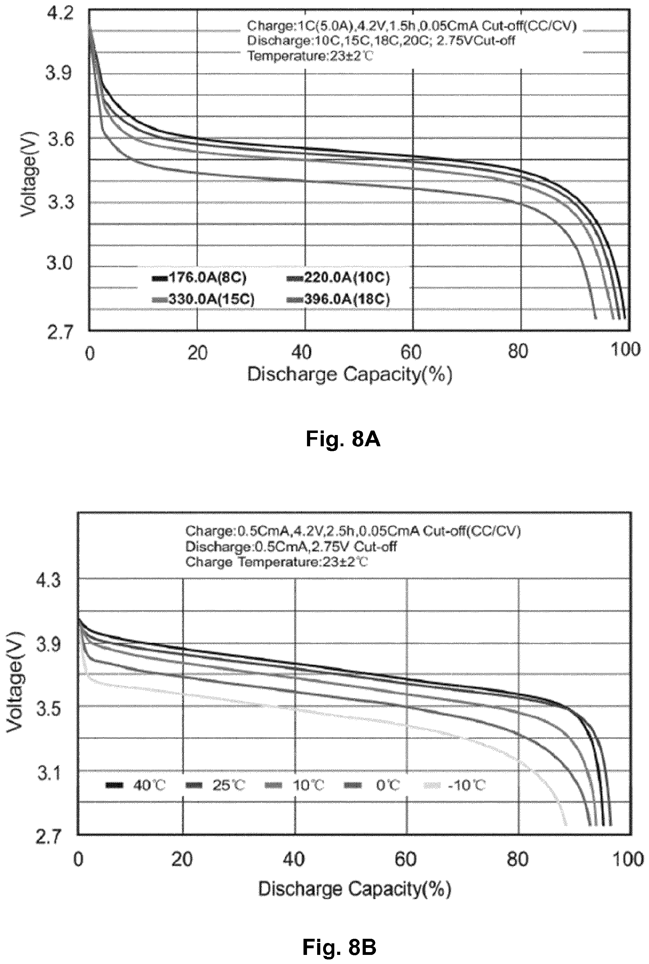

Figures 8A and 8B schematically depict voltage discharge characteristics of a LIPO battery cell as functions of discharge current and temperature, respectively. It can be seen that the voltage output of the battery cell varies continuously over the discharge cycle. The voltage output also varies with temperature. Hence, the energy supply 310 further comprises the voltage regulator 314, specifically a DC to DC converter, arranged to regulate a voltage at which the electrical energy is supplied by the energy supply 310 to the electrical device 320 and thus generate a stable voltage output during a discharge cycle of the electrochemical cell 311.

Although a few preferred embodiments have been shown and described, it will be appreciated by those skilled in the art that various changes and modifications might be made without departing from the scope of the invention, as defined in the appended claims.

For example, while the energy supply comprises an electrochemical cell and is arranged to supply up to an amount of electrical energy to the electrical device, the energy supply may additionally and/or alternatively comprise a capacitor, for example a super capacitor, arranged to supply at least part of up to the amount of electrical energy to the electrical device. Generally, supercapacitors (SC) (also known as electric double-layer capacitor (EDLC), supercap, ultracapacitor or Goldcap) are high-capacity capacitors with capacitance values higher than other capacitors (but lower voltage limits) that bridge the gap between electrolytic capacitors and rechargeable batteries. They typically store 10 to 100 times more energy per unit volume or mass than electrolytic capacitors, can accept and deliver charge much faster than batteries, and tolerate many more charge and discharge cycles than rechargeable batteries. Supercapacitors typically use electrostatic double-layer capacitance and electrochemical pseudocapacitance, both of which contribute to the total capacitance of the capacitor, however, with different amounts. Electrostatic double-layer capacitors use carbon electrodes or derivatives with much higher electrostatic double-layer capacitance than electrochemical pseudocapacitance, achieving separation of charge in a Helmholtz double layer at the interface between the surface of a conductive electrode and an electrolyte. The separation of charge is of the order of a few ångströms (0.3-0.8 nm), much smaller than in a conventional capacitor. Electrochemical pseudocapacitors use metal oxide or conducting polymer electrodes with a high amount of electrochemical pseudocapacitance additional to the double-layer capacitance. Pseudocapacitance is achieved by Faradaic electron charge-transfer with redox reactions, intercalation or electrosorption. Hybrid capacitors, such as the lithium-ion capacitor, use electrodes with differing characteristics: one exhibiting mostly electrostatic capacitance and the other mostly electrochemical capacitance.

In summary, a system comprising an energy supply, an electrical device and a heat exchanger including a coolant fluid and a phase change material (PCM) arranged to, in use, control, at least in part, a temperature of the coolant fluid, is provided. The energy supply and heat exchanger including the coolant fluid and the PCM provide portability of the system, thereby allowing manual handling of the system by an operator and/or operation of the electrical device remotely from mains electrical supplies, for example, while providing sufficient thermal management for the electrical device during the operation time.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims and drawings), and/or all of the steps of any method or process so disclosed, may be combined in any combination, except combinations where at least some of such features and/or steps are mutually exclusive.

Each feature disclosed in this specification (including any accompanying claims, and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims and drawings), or to any novel one, or any novel combination, of the steps of any method or process so disclosed.

## Claims

1. A system comprising an energy supply, an electrical device and a heat exchanger including a coolant fluid;
wherein the energy supply comprises an electrochemical cell and is arranged to supply up to an amount of electrical energy to the electrical device;
wherein an operation time of the electrical device, in use, is defined, at least in part, by the amount of electrical energy supplied by the energy supply;
wherein the electrical device is arranged to output, in use, at least a part of the supplied energy as heat to the heat exchanger via the coolant fluid; and
wherein the heat exchanger comprises a phase change material (PCM) arranged to, in use, control, at least in part, a temperature of the coolant fluid to at most a first threshold temperature during the operation time;
whereby portability of the system is provided.

2. The system according to claim 1, wherein a phase change temperature of the PCM is at most the first threshold temperature and/or at least ambient temperature, in use.

3. The system according to any previous claim, wherein the heat exchanger is arranged to control the temperature of the coolant fluid to at most the first threshold temperature during at most the operation time.

4. The system according to any previous claim, wherein the coolant fluid comprises a liquid, preferably water.

5. The system according to any previous claim, wherein the system comprises a pump arranged to circulate the coolant fluid.

6. The system according to any previous claim, wherein the PCM comprises at least one of an organic PCM, an inorganic PCM, an eutectic PCM, a hygroscopic PCM, a solid-solid PCM and a thermal composite.

7. The system according to any previous claim, wherein the PCM comprises an encapsulated PCM.

8. The system according to any previous claim, wherein the PCM comprises an additive arranged to increase a thermal conductivity of the PCM.

9. The system according to any previous claim, wherein the electrochemical cell comprises a rechargeable electrochemical cell.

10. The system according to any previous claim, wherein the system comprises a voltage regulator arranged to regulate a voltage at which the electrical energy is supplied by the energy supply to the electrical device.

11. The system according to any previous claim, wherein the electrical device comprises a laser power supply.

12. The system according to any previous claim, wherein the heat exchanger comprises a cooling fin.

13. The system according to any previous claim, wherein the heat exchanger is arranged to accommodate expansion and/or contraction of the PCM.

14. The system according to any previous claim, wherein the system comprises a thermoelectric heat pump.

15. A heat exchanger including a coolant fluid;
wherein the heat exchanger comprises a phase change material (PCM) arranged to, in use, control, at least in part, a temperature of the coolant fluid to at most a first threshold temperature during an operation time.
